# EUROPÄISCHE PATENTANMELDUNG

(11) **EP 3 089 567 A1**
(43) Veröffentlichungstag der Anmeldung: **02.11.2016**
(21) Anmeldenummer: 16158093.1
(22) Anmeldetag: 01.03.2016
(51) Int. Cl.: H05K 3/00, H05K 7/20, H05K 1/02

(54) **ELEKTRONISCHE BAUGRUPPE, INSBESONDERE FÜR EIN GETRIEBESTEUERMODUL**

(30) Priorität: 29.04.2015 DE 102015207893
(71) Anmelder: ROBERT BOSCH GMBH, 70442 Stuttgart (DE)
(72) Erfinder: Liskow, Uwe, 71679 Asperg (DE)

(57) **Zusammenfassung**

Für eine elektronische Baugruppe (1), insbesondere für ein Getriebesteuermodul, umfassend eine mit wenigstens einem wärmeerzeugenden elektrischen Bauelement (2) auf einer ersten Seite bestückte Leiterplatte (3), einen Kühlkörper (4) und einen die Leiterplatte (3) mit dem Kühlkörper (4) verbindenden Kleberauftrag (5), der zumindest teilweise in einem Spalt (12) zwischen einer von der ersten Seite (20) abgewandten zweiten Seite (21) der Leiterplatte (3) und dem Kühlkörper (4) angeordnet ist, wobei in dem mit dem Kleberauftrag (5) versehenen Spalt (12) zusätzlich wenigstens ein Wärmeleitkörper (61) zwischen der von der ersten Seite (20) abgewandten zweiten Seite (21) der Leiterplatte (3) und dem Kühlkörper (4) angeordnet ist,
wird vorgeschlagen, den wenigstens einen Wärmeleitkörper (61) als federelastisches, zwischen den Kühlkörper (4) und die zweite Seite (21) der Leiterplatte (3) eingeklemmtes Einlegeteil (6) auszubilden.

## Beschreibung

### Stand der Technik

Die Erfindung betrifft eine elektronische Baugruppe, insbesondere für ein Getriebesteuermodul, mit den Merkmalen des Oberbegriffs des unabhängigen Anspruchs 1.

In der Kraftfahrzeugtechnik werden zur Getriebeansteuerung am Getriebe verbaute elektronische Steuermodule verwendet. Die Leiterplatten der Steuermodule können Aktuatoren, Sensoren, Stecker, wenigstens ein gekapseltes Steuergerät (TCU, Transmission Control Unit) und weitere Komponenten aufweisen. Um die von elektrischen Bauelementen auf der Leiterplatte abgegebene Wärme möglichst gut abzuleiten, ist es bekannt, die Leiterplatten flächig mit einem wärmeleitenden Klebstoff auf eine als Kühlkörper dienende Basisplatte aufzukleben.

Eine gängige Verbundanordnung von wärmeerzeugenden elektrischen Bauelementen auf einer Leiterplatte mit einer als Kühlkörper dienenden Grundplatte besteht darin, einen Kleberauftrag aufzubringen, in dem Kleberauftrag Inseln auszusparen und diese mit Wärmeleitpaste zu füllen. So zeigt beispielsweise die DE 39 32 213 A1 eine derart gefertigte Verbundanordnung bei der die Inseln aus Wärmeleitpaste unterhalb von Bereichen der Leiterplatte, die mit Bauelementen hoher Verlustleistung bestückt sind, angeordnet sind.

Ferner ist aus DE 197 29 073 A1 ein Verfahren zur Herstellung einer Klebeverbindung zwischen einem elektronischen Bauelement und einem Trägersubstrat bekannt, bei dem durch das Trägersubstrat geführte Entlüftungsöffnungen vorgesehen sind, durch die in einem Spalt befindliche und vom Kleber eingeschlossene Luft entweichen kann.

### Offenbarung der Erfindung

Erfindungsgemäß wird eine elektronische Baugruppe, insbesondere für ein Getriebesteuermodul, vorgeschlagen. Diese umfasst eine mit wenigstens einem wärmeerzeugenden elektrischen Bauelement auf einer ersten Seite bestückte Leiterplatte, einen Kühlkörper und einen die Leiterplatte mit dem Kühlkörper verbindenden Kleberauftrag, der zumindest teilweise in einem Spalt zwischen einer von der ersten Seite abgewandten zweiten Seite der Leiterplatte und dem Kühlkörper angeordnet ist, wobei in dem mit dem Kleberauftrag versehenen Spalt zusätzlich wenigstens ein Wärmeleitkörper zwischen der von der ersten Seite abgewandten zweiten Seite der Leiterplatte und dem Kühlkörper angeordnet ist, dadurch gekennzeichnet, dass der wenigstens eine Wärmeleitkörper als federelastisches, zwischen den Kühlkörper und die zweite Seite der Leiterplatte eingeklemmtes Einlegeteil ausgebildet ist.

### Vorteile der Erfindung

Neben der Ableitung der von dem wenigstens einem elektrischen Bauelement erzeugten Wärme hat die elektronische Baugruppe den Vorteil, dass durch die Vorspannung des federelastischen Einlegeteiles ein sicheres Anliegen des Einlegeteiles an die dem Einlegeteil zugewandten Oberflächen der Leiterplatte und des Kühlkörpers gewährleistet wird. Zudem kann das eingespannte federelastischen Einlegeteil durch die Vorspannung Toleranzen und Unebenheiten in der dem Einlegeteil zugewandten Seite der Leiterplatte und der dem Einlegeteil zugewandten Seite des Kühlkörpers ausgleichen. Darüber hinaus kann die elektronische Baugruppe in einer automatischen Fertigungslinie einfacher gehandhabt werden, da das aufwändige Applizieren eines Wärmeleitklebers in selektiven Bereichen zwischen Leiterplatte und Kühlkörper entfällt. Im Gegensatz zu einem vollflächigen Kleberauftrag, der die gesamte zweite Seite der Leiterplatte flächig bedeckt kann der Kleberauftrag beispielsweise auch nur am Rand der Leiterplatte, das Einlegeteil umlaufend, aufgetragen werden. Somit kann der Kleberauftrag für Licht oder Wärmestrahlung zugänglich gemacht werden und licht- oder wärmeaushärtender Kleberauftrag verwendet werden, der eine vorteilhafte Produktion ermöglicht.

Weitere vorteilhafte Ausgestaltungen und Weiterbildungen der Erfindung werden durch die in den Unteransprüchen angegebenen Merkmale ermöglicht.

Besonders vorteilhaft ist die Fertigung des Einlegeteiles aus Metall, da durch die hohe Wärmeleitfähigkeit die abgegebene Verlustleistung besonders effektiv abgeleitet werden kann. Es können auch wärmeleitende Kunststoffe eingesetzt werden, die eine höhere Wärmeleitfähigkeit als Wärmeleitkleber aufweisen.

Wenn das Einlegeteil als flächenartige Struktur mit ersten Stützabschnitten, welche sich an der zweiten Seite der Leiterplatte abstützen, und zweiten Stützabschnitten, welche sich an dem Kühlkörper abstützen, ausgebildet ist, ergibt sich der Vorteil, dass das Einlegeteil durch die Vielzahl der Stützabschnitte sowohl einen guten Wärmeleitkontakt mit der Leiterplatte, als auch einen guten Wärmeleitkontakt mit dem Kühlkörper aufweist und gleichzeitig in einfacher Weise zwischen Kühlkörper und Leiterplatte eingeklemmt werden kann.

Sind die ersten und zweiten Stützabschnitte so gefertigt, dass sie sich alternierend an der zweiten Seite der Leiterplatte und an dem Kühlkörper abstützen, so kann über einen parallel zur Leiterplatte ausgedehnten Bereich im Spalt ein gleichmäßiger Kontakt zwischen dem Einlegeteil und der Leiterplatte einerseits und dem Einlegeteil und dem Kühlkörper andererseits gewährleistet werden. So wird die von den elektrischen Bauelementen auf der Leiterplatte abgegebene Wärme quasi flächig abgeleitet. Dabei wird durch die alternierende Anordnung über die gesamte Flächenerstreckung des Einlegeteils ein vorteilhafter kurzer Wärmeableitweg zwischen Kühlkörper und Leiterplatte sichergestellt. Darüber hinaus kann das Einlegeteil durch die alternierenden ersten und zweiten Stützabschnitte stabil zwischen die Leiterplatte und den Kühlkörper eingeklemmt werden.

Weist das Einlegeteil in einer Richtung senkrecht zur Leiterplatte gesehen im nicht eingeklemmtem Zustand eine größere Dicke als die durch den ausgehärteten Kleberauftrag definierte Spaltbreite auf, kann beispielsweise vorteilhaft bei der Fertigung auch ein sich bei der Aushärtung zusammenziehender Klebstoff eingesetzt werden, so dass das Einlegeteil während des Aushärtevorganges automatisch durch die Verringerung der Spaltbreite zwischen Leiterplatte und Kühlkörper einklemmt wird. Eine andere einfache Möglichkeit zum Einklemmen des Einlegeteiles ist die Anwendung von Druck zwischen der Leiterplatte und dem Kühlkörper senkrecht zur Leiterplatte während des Aushärtevorganges.

Ist das Einlegeteil in Kontakt mit dem umliegenden Medium beispielsweise einem Getriebefluid, ist es vorteilhaft derart beschaffen, dass es von diesem Medium nicht beschädigt wird. Wird aus Kostengründen beispielsweise als Einlegeteil ein Material mit hoher Wärmeleitfähigkeit aber geringer Medienbeständigkeit verwendet, erweist es sich als vorteilhaft, das Einlegeteil und den Kleberauftrag derart anzubringen, dass der Kleberauftrag wenigstens eine innere Ausnehmung aufweist, in der das Einlegeteil angeordnet ist. Das Einlegeteil ist in dem Spalt zwischen Leiterplatte und Kühlkörper somit vollständig umlaufend vom Kleberauftrag umgeben und damit vor dem umgebenden Medium geschützt. Somit kann auf die Medienbeständigkeit des Einlegteiles beispielsweise auch verzichtet werden. Besonders gut wärmeleitende Folien weisen oft eine schlechte Medienresistenz auf, weshalb ein das Einlegeteil vollständig umlaufender Kleberauftrag beim Einsatz solcher Folien sehr vorteilhaft sein kann.

Wird der Klebstoff im Wärmeofen ausgehärtet kann sich die zwischen Leiterplatte und Kühlkörper eingeschlossene Luft ausdehnen. In diesem Fall erweisen sich Ausgaskanäle in der Leiterplatte und/oder dem Kühlkörper, die die innere Ausnehmung mit dem Außenraum der elektronischen Baugruppe verbinden als vorteilhaft, da durch diese die sich ausdehnende Luft entweichen kann.

Falls ein gegenüber Getriebefluid empfindlicher Kleberauftrag eingesetzt wird, kann die Anordnung der elektronischen Baugruppe im Getriebefluid eine besondere Belastung für den Kleberauftrag darstellen. In diesem Fall erweist es sich als vorteilhaft, ein gegenüber dem Getriebefluid resistentes Einlegeteil mit einer inneren Ausnehmung, die in dem Spalt umlaufend vom Einlegeteil umgeben ist, einzusetzen. Wenn in dieser Ausnehmung der Kleberauftrag eingebracht wird, ist dieser somit vom umgebenden Einlegeteil vor dem Getriebefluid geschützt.

Um eine effektive Wärmeableitung über das Einlegeteil zu gewährleisten, ist es vorteilhaft das wärmeleitende Einlegeteil unterhalb der wärmeerzeugenden elektrischen Bauelemente anzuordnen. Je nach Anordnung der wärmeerzeugenden elektrischen Bauelemente auf der Leiterplatte kann es dabei vorteilhaft sein, den Kleberauftrag ein-oder mehrteilig in dem Spalt anzubringen.

Aufgrund mechanischer oder thermischer Spannungen in der elektronischen Baugruppe kann es vorkommen, dass die zweite Seite der Leiterplatte und/oder die der Leiterplatte zugewandte Seite des Kühlkörpers leicht uneben geformt sind. Das federelastische Einlegeteil passt sich vorteilhaft präzise und stabil an die Unebenheiten an, so dass weiterhin eine optimale Wärmeableitung gewährleistet ist.

### Kurze Beschreibung der Zeichnungen

Ausführungsbeispiele der Erfindung sind in der Zeichnung dargestellt und werden in der nachfolgenden Beschreibung näher erläutert. Es zeigen
Fig. 1 eine Anordnung einer erfindungsgemäßen elektronischen Baugruppe als Teil eines Getriebesteuermoduls in einem Kraftfahrzeuggetriebe,
Fig. 2 einen Querschnitt durch ein erstes Ausführungsbeispiel der erfindungsgemäßen elektronischen Baugruppe,
Fig. 3 einen Schnitt der in Fig. 2 dargestellten elektronischen Baugruppe entlang der Ebene des Kleberauftrages und des Einlegeteiles in dem Spalt zwischen der Leiterplatte und dem Kühlkörper,
Fig. 4 ein zweites Ausführungsbeispiel,
Fig. 5 einen Schnitt der in Fig. 4 dargestellten elektronischen Baugruppe entlang der Ebene des Kleberauftrages und des Einlegeteiles in dem Spalt zwischen der Leiterplatte und dem Kühlkörper,
Fig. 6 ein drittes Ausführungsbeispiel,
Fig. 7 einen Schnitt der in Fig. 6 dargestellten elektronischen Baugruppe entlang der Ebene des Kleberauftrages und des Einlegeteiles in dem Spalt zwischen der Leiterplatte und dem Kühlkörper.

### Ausführungsformen der Erfindung

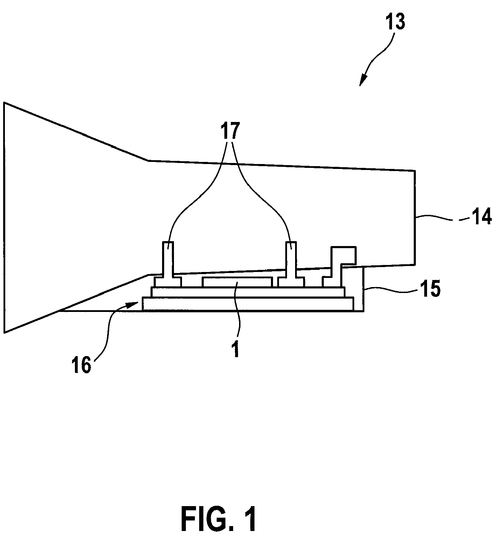

Fig. 1 zeigt ein Kraftfahrzeuggetriebe 13, das eine Getriebebox 14 und eine an der Getriebebox 14 angebrachte Getriebewanne 15 umfasst, in einer stark vereinfachten und schematischen Darstellung. Innerhalb der wenigstens teilweise mit einem Getriebefluid gefüllten Getriebewanne 15 ist ein Getriebesteuermodul 16, das eine elektronische Baugruppe 1 und mit ihr kontaktierte weitere elektrische oder elektronische Komponenten 17 umfasst, angeordnet.

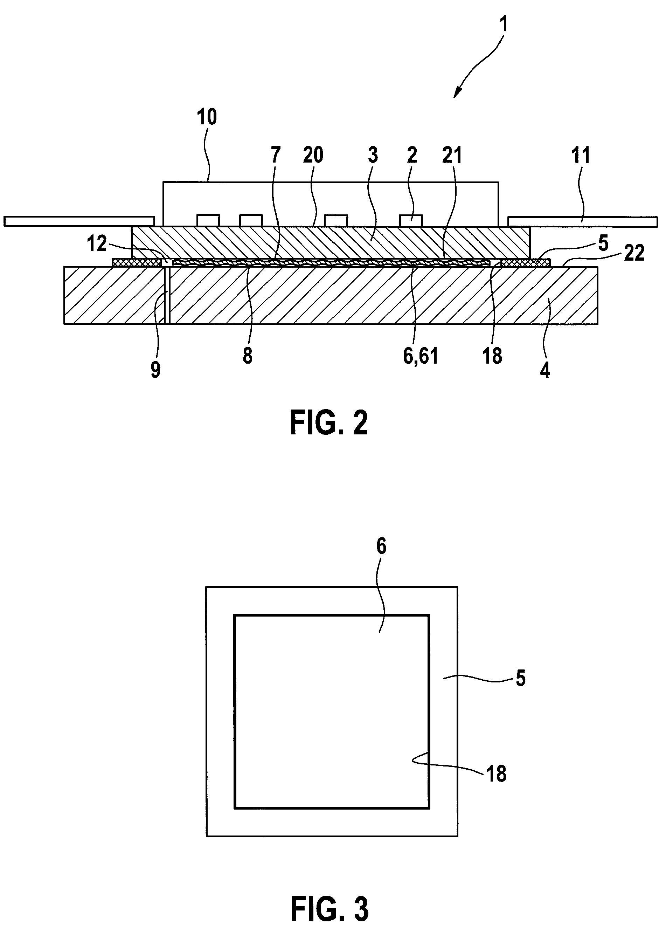

Fig. 2 zeigt einen schematischen Querschnitt durch ein Ausführungsbeispiel der elektronische Baugruppe 1, welche Teil des Getriebesteuermoduls 16 sein kann, das an dem und in dem Kraftfahrzeuggetriebe 13 verbaut wird. Die elektronische Baugruppe 1 kann aber auch außerhalb des Getriebesteuermoduls 16 eingesetzt werden. Die elektronische Baugruppe 1 umfasst einen Kühlkörper 4, eine Leiterplatte 3, die auf der ersten Seite 20 mit wenigstens einem wärmeerzeugenden elektrischen Bauelement 2 bestückt ist, und einen Spalt 12 zwischen einer von der ersten Seite 20 abgewandten zweiten Seite 21 der Leiterplatte 3 und dem Kühlkörper 4. In dem Spalt 12 ist ein als Wärmeleitkörper 61 dienendes Einlegeteil 6 und zumindest teilweise ein die Leiterplatte 3 mit dem Kühlkörper 4 verbindender Kleberauftrag 5 angeordnet.

Der Kühlkörper 4 besteht aus einem wärmeleitenden Material beispielsweise aus Aluminium. In diesem Beispiel handelt es sich bei der Leiterplatte 3 um eine starre Leiterplatte, beispielsweise um eine Leiterplatte in FR4-Ausführung oder höherwertig, also beispielsweise um eine Leiterplatte aus glasfaserverstärktem Epoxidharz. Die Leiterplatte 3 kann aber auch eine HDI-Leiterplatte (High Density Interconnect-Leiterplatte), eine LTCC (Low Temperature Cofired Ceramics) oder eine andere geeignete starre Leiterplatte sein. Auf der ersten Seite 20 der Leiterplatte 3 sind ein oder mehrere, miteinander durch Leiterbahnen verbundene, wärmeerzeugende elektrische Bauelemente 2 angeordnet. Es kann sich um ein einzelnes wärmeerzeugendes Bauelement oder mehrere über Leiterbahnen der Leiterplatte 3 elektrisch verbundene und eine Steuerschaltung bildende Bauelemente handeln. Die Leiterplatte 3 ist über elektrische Anschlusselemente 11, beispielsweise flexible elektrische Leiterplatten (FPC = Flexible Printed Circuit Board), Kabel oder Stanzgitter, mit anderen außerhalb der elektronischen Baugruppe 1 angeordneten und in Fig. 2 nicht abgebildeten elektrischen oder elektronischen Komponenten, beispielsweise Sensoren, Aktuatoren und Steckerteilen, elektrisch kontaktiert. Die zweite Seite der Leiterplatte 3 ist durch den Kleberauftrag 5 auf den Kühlkörper 4 aufgeklebt.

Das Einlegeteil 6 ist ein wärmeleitender, federelastischer Festkörper, der vor dem Aushärtevorgang des Kleberauftrages 5 in den Spalt 12 zwischen Leiterplatte 3 und Kühlkörper 4 eingelegt werden kann. Das Einlegeteil 6 kann beispielsweise aus Metall oder wärmeleitendem Kunststoff bestehen. Unter einem Einlegeteil wird im Kontext der vorliegenden Anmeldung ein einstückiges oder mehrgliedriges und mechanisch zusammenhängendes Bauteil verstanden, das im fertigen Zustand auf den Kühlkörper 4 oder die Leiterplatte 3 manuell oder durch eine Bestückungsvorrichtung auflegbar ist. Nach dem Aushärtevorgang des Kleberauftrages 5 ist das Einlegeteil 6 zwischen der Leiterplatte 3 und dem Kühlkörper 4 eingeklemmt.

Das Einklemmen des Einlegeteiles 6 kann dadurch erreicht werden, dass während des Aushärtens des Kleberauftrages 5 die Leiterplatte 3 auf den Kleberauftrag 5 und das Einlegeteil 6 gedrückt wird. Zusätzlich oder alternativ kann ein sich beim Aushärtungsprozess zusammenziehender Klebestoff verwendet werden, so dass bei der Aushärtung des Kleberauftrages 5 die Folie automatisch durch die Verringerung der Breite des Spaltes 12 zwischen Leiterplatte 3 und Kühlkörper 4 einklemmt wird.
Der Kleberauftrag 5 verbindet die Leiterplatte 3 mit dem Kühlkörper 4 und kann dabei wie in Fig. 2 dargestellt teilweise innerhalb und teilweise außerhalb des durch die zweite Seite 21 der Leiterplatte 3 und durch die der zweiten Seite 21 der Leiterplatte 3 zugewandten Seite 22 des Kühlkörpers definierten Spaltes 12 angeordnet sein. Wird beispielsweise während des Aushärtens des Kleberauftrages 5 die Leiterplatte 3 auf den Kleberauftrag 5 und das Einlegeteil 6 gedrückt, kann es beispielsweise vorkommen, dass der vor dem Andrücken vollständig innerhalb des Spaltes 12 angeordnete Kleberauftrag 5 teilweise aus dem Spalt 12 heraustritt. Der Kleberauftrag 5 kann beispielsweise auch vollständig im Spalt 12 angeordnet sein, so dass der Kleberauftrag 5 nur mit der zweiten Seite 21 der Leiterplatte 3 und der der zweiten Seite 21 der Leiterplatte 3 zugewandten Seite 22 des Kühlkörpers 4 in Kontakt steht und nicht über den durch diese zwei Seiten definierten Spalt 12 hinausgeht. Wird das dargestellte Ausführungsbeispiel der Baugruppe 1 beispielsweise im Kraftfahrzeuggetriebe 13 eingesetzt, kann der den Kleberauftrag 5 bildende Klebstoff vorteilhaft derart beschaffen sein, dass er beständig gegen das in der Getriebebox 14 befindliche Getriebefluid ist. Aufgrund der guten Wärmeleitfähigkeit des Einlegeteiles 6 kann aus Kostengründen auf gute Wärmeleitfähigkeit des Klebstoffes beispielsweise auch verzichtet werden.

Das Einlegeteil 6 ist im dargestellten Ausführungsbeispiel der Fig. 2 als flächenartige Struktur ausgebildet, die erste Stützabschnitte 7, welche sich an der zweiten Seite der Leiterplatte 3 abstützten, und zweite Stützabschnitte 8, die sich an einer Seite 22 des Kühlkörpers 4 abstützen, aufweist. Durch die Einklemmung der federelastischen und flächenartigen Struktur zwischen Leiterplatte 3 und Kühlkörper 4 stehen die ersten Stützabschnitte 7 mit der Leiterplatte 3 und die zweiten Stützabschnitte 8 mit dem Kühlkörper 4 in wärmeleitendem Kontakt. Die als Einlegeteil 6 dienende flächenartige Struktur mit den ersten Stützabschnitten 7 und den zweiten Stützabschnitten 8 kann beispielsweise eine wellenartige, eine genapfte, eine zickzackartige oder eine ähnliche Struktur aufweisen.

Durch mechanische oder thermische Spannungen in der elektronischen Baugruppe 1 kann es vorkommen, dass die zweite Seite 21 der Leiterplatte 3 und/oder die der Leiterplatte 3 zugewandte Seite 22 des Kühlkörpers 4 leicht uneben geformt sind. Das Einlegeteil 6 passt sich vorteilhaft den Unebenheiten an, so dass eine optimale Wärmeableitung gewährleistet ist.

Fig. 3 zeigt einen Schnitt der in Fig. 2 dargestellten elektronischen Baugruppe 1 entlang der Ebene des Kleberauftrages 5 und des Einlegeteiles 6 in dem Spalt 12 zwischen der Leiterplatte 3 und dem Kühlkörper 4. Wie zu erkennen ist, weist in diesem Ausführungsbeispiel der Kleberauftrag 5 eine innere Ausnehmung 18 auf, die in dem Spalt 12 umlaufend von dem Kleberauftrag 5 umgeben ist, wobei das Einlegeteil 6 in der inneren Ausnehmung 18 angeordnet ist. Damit sich beim Aushärteprozess ausdehnende Luft aus der inneren Ausnehmung 18 entweichen kann, ist in diesem Ausführungsbeispiel ein in Fig. 2 gezeigter Ausgaskanal 9 in dem Kühlkörper 4 angeordnet, der die innere Ausnehmung 18 mit dem Außenbereich der elektronischen Baugruppe 1 verbindet. Der Ausgaskanal 9 kann beispielsweise auch in der Leiterplatte 3 angeordnet sein und durch diese hindurch die innere Ausnehmung 18 mit dem Außenbereich der elektronischen Baugruppe 1 verbinden. Die Leiterplatte 3 ist in diesem Ausführungsbeispiel über elektrische Anschlusselemente 11 mit weiteren, außerhalb der elektronischen Baugruppe 1 angeordneten, elektrischen oder elektronischen Komponenten beispielsweise mit Sensoren kontaktiert.

Um die auf der ersten Seite 20 der Leiterplatte 3 angeordneten elektrischen Bauelemente 2 vor dem in der Getriebebox 14 vorhandenen Getriebefluid zu schützen, ist in diesem Beispiel auf der ersten Seite 20 der Leiterplatte 3 eine in Fig. 2 dargestellte Schutzabdeckung 10 aufgebracht, welche die elektrischen Bauelemente 2 nach außen dichtend abdeckt. Die Schutzabdeckung 10 kann beispielsweise einen Gehäusedeckel, eine Moldmasse, einen Verguss oder einen Lack umfassen.

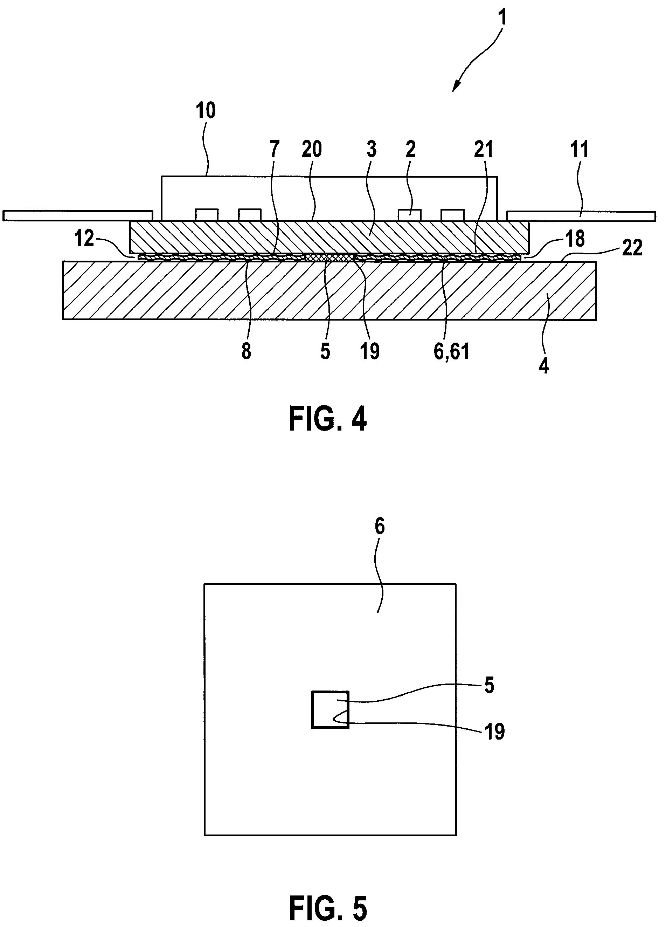

Fig. 4 offenbart ein zweites Ausführungsbeispiel, bei dem das Einlegeteil 6 eine innere Ausnehmung 19 aufweist, die in dem Spalt 12 umlaufend vom Einlegeteil 6 umgeben ist und in der der Kleberauftrag 5 angeordnet ist. Fig. 5 zeigt einen Schnitt der in Fig. 4 dargestellten elektronischen Baugruppe 1 entlang der Ebene des Kleberauftrages 5 und des Einlegeteiles 6 in dem Spalt 12 zwischen der Leiterplatte 3 und dem Kühlkörper 4. Das Einlegeteil 6 ist in diesem Ausführungsbeispiel resistent gegen das Getriebefluid und schließt, die innere Ausnehmung 19 umlaufend, dicht mit der zweiten Seite 21 der Leiterplatte 3 und der der zweiten Seite 21 der Leiterplatte 3 gegenüberliegenden Seite des Kühlkörpers 4 ab. Somit verhindert das Einlegeteil 6 das Eindringen des Getriebefluides in die innere Ausnehmung 19 und schützt den Kleberauftrag 5 vor dem Getriebefluid. Daher kann ein kostengünstiger, dem Getriebefluid gegenüber empfindlicher Klebstoff für den Kleberauftrag 5 verwendet werden kann.

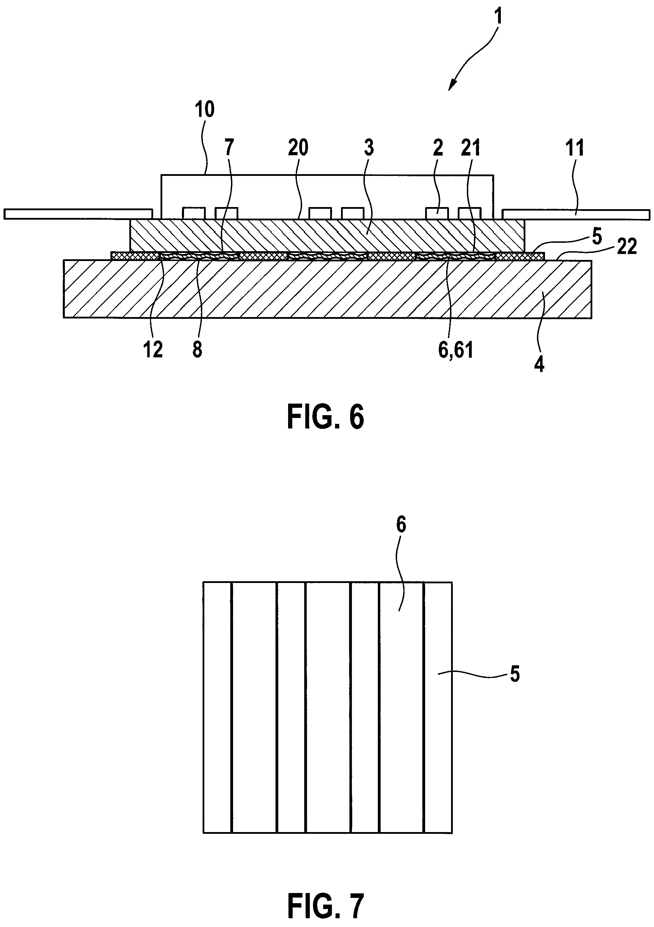

Fig. 6 offenbart ein drittes Ausführungsbeispiel, bei der der Kleberauftrag 5 mehrteilig ausgebildet ist und mehrere Einlegeteile 6 zwischen der Leiterplatte 3 und dem Kühlkörper 4 angeordnet sind. Fig. 7 zeigt einen Schnitt der in Fig. 6 dargestellten elektronischen Baugruppe 1 entlang der Ebene des Kleberauftrages 5 und der Einlegeteile 6 durch den Spalt 12 zwischen der Leiterplatte 3 und dem Kühlkörper 4. Bei diesem Ausführungsbeispiel sind streifenförmige Flächen von Kleberauftrag 5 und streifenförmige Einlegeteile 6 alternierend angeordnet. Die Einlegeteile 6 sind dabei unterhalb der auf der ersten Seite der Leiterplatte 3 angeordneten elektrischen Bauelemente 2 angeordnet, was eine Verbesserung der Ableitung der von den Bauelementen 2 erzeugten Wärme zum Kühlkörper 4 bewirkt. Durch den mehrteiligen Kleberauftrag 5 wird die Leiterplatte 3 sowohl am Rand des Spaltes 12 als auch im Inneren des Spaltes 12 mit dem Kühlkörper 4 verbunden.

Selbstverständlich sind noch weitere Ausführungsbeispiele und Mischformen der dargestellten Ausführungsbeispiele möglich.

## Patentansprüche

1. Elektronische Baugruppe (1), insbesondere für ein Getriebesteuermodul, umfassend eine mit wenigstens einem wärmeerzeugenden elektrischen Bauelement (2) auf einer ersten Seite bestückte Leiterplatte (3), einen Kühlkörper (4) und einen die Leiterplatte (3) mit dem Kühlkörper (4) verbindenden Kleberauftrag (5), der zumindest teilweise in einem Spalt (12) zwischen einer von der ersten Seite (20) abgewandten zweiten Seite (21) der Leiterplatte (3) und dem Kühlkörper (4) angeordnet ist, wobei in dem mit dem Kleberauftrag (5) versehenen Spalt (12) zusätzlich wenigstens ein Wärmeleitkörper (61) zwischen der von der ersten Seite (20) abgewandten zweiten Seite (21) der Leiterplatte (3) und dem Kühlkörper (4) angeordnet ist,
**dadurch gekennzeichnet, dass** der wenigstens eine Wärmeleitkörper (61) als federelastisches, zwischen den Kühlkörper (4) und die zweite Seite (21) der Leiterplatte (3) eingeklemmtes Einlegeteil (6) ausgebildet ist.

2. Elektronische Baugruppe nach Anspruch 1, **dadurch gekennzeichnet, dass** das Einlegeteil (6) wenigstens teilweise aus Metall oder wärmeleitendem Kunststoff gefertigt ist.

3. Elektronische Baugruppe nach einem der vorhergehenden Ansprüche, **dadurch gekennzeichnet, dass** das Einlegeteil (6) mit einer flächenartigen Struktur versehen ist, die erste Stützabschnitte (7), welche sich an der zweiten Seite (21) der Leiterplatte (3) abstützten, und zweite Stützabschnitte (8), die sich an dem Kühlkörper (4) abstützen, aufweist.

4. Elektronische Baugruppe nach Anspruch 3, **dadurch gekennzeichnet, dass** die flächenartige Struktur derart gefertigt ist, dass die ersten Stützabschnitte (7) und zweiten Stützabschnitte (8) alternierend auftreten.

5. Elektronische Baugruppe nach einem der vorhergehenden Ansprüche, **dadurch gekennzeichnet, dass** das Einlegeteil (6) im nicht eingeklemmten Zustand in einer Richtung senkrecht zur Leiterplatte (3) gesehen eine Dicke aufweist, die größer als die durch den ausgehärteten Kleberauftrag (5) definierte Spaltbreite in dieser Richtung ist.

6. Elektronische Baugruppe nach einem der vorhergehenden Ansprüche, **dadurch gekennzeichnet, dass** der Kleberauftrag (5) wenigstens eine innere Ausnehmung (18) aufweist, die in dem Spalt (12) umlaufend von dem Kleberauftrag (5) umgeben ist, wobei das Einlegeteil (6) in der inneren Ausnehmung (18) angeordnet ist.

7. Elektronische Baugruppe nach Anspruch 6, **dadurch gekennzeichnet, dass** die innere Ausnehmung (18) über wenigstens einen Ausgaskanal (9) in dem Kühlkörper (4) und/oder in der Leiterplatte (3) mit dem Außenraum der elektronischen Baugruppe (1) in Verbindung steht.

8. Elektronische Baugruppe nach einem der Ansprüche 1 bis 5, **dadurch gekennzeichnet, dass** das Einlegeteil (6) resistent gegenüber Getriebefluid ausgebildet ist und dass das Einlegeteil (6) wenigstens eine innere Ausnehmung (19) aufweist, die in dem Spalt (12) umlaufend vom Einlegeteil (6) umgeben ist, wobei der Kleberauftrag (5) durch das Einlegeteil (6) geschützt in der inneren Ausnehmung (19) angeordnet ist.

9. Elektronische Baugruppe nach einem der Ansprüche 1 bis 5 **dadurch gekennzeichnet, dass** der Kleberauftrag (5) in dem Spalt (12) ein- oder mehrteilig ausgebildet ist.

10. Elektronische Baugruppe nach Anspruch 1, **dadurch gekennzeichnet, dass** die zweite Seite (21) der Leiterplatte (3) und/oder die der Leiterplatte (3) zugewandte Seite (22) des Kühlkörpers (4) uneben geformt ist.
